# FASCICULE DE BREVET EUROPEEN

(11) **EP 2 677 361 B1**
(45) Date de publication et mention de la délivrance du brevet: **05.08.2015**
(21) Numéro de dépôt: 13172292.8
(22) Date de dépôt: 17.06.2013
(51) Int. Cl.: G02F 1/1362

(54) **Panneau constitué d'une matrice de cellules à cristaux liquides destiné à être utilisé dans un nanoprojecteur**
Paneel aus einer Zellmatrix aus Flüssigkristallen zur Verwendung in einem Nanoprojektor
Panel comprising an array of liquid crystal cells for use in a nano-projector

(30) Priorité: 19.06.2012 FR 1255732
(43) Date de publication de la demande: 25.12.2013
(73) Titulaire: STmicroelectronics SA, 92120 Montrouge (FR); COMMISSARIAT A L'ENERGIE ATOMIQUE ET AUX ENERGIES ALTERNATIVES, 75015 Paris (FR)
(72) Inventeur: Marty, Michel, 38760 SAINT PAUL DE VARCES (FR); Hirigoyen, Flavien, 38000 GRENOBLE (FR); Segura Puchades, Josep, 38600 FONTAINE (FR); Wehbe-Alause, Hélène, 38660 LE TOUVET (FR); Rossini, Umberto, 38500 COUBLEVIE (FR)
(74) Mandataire: Thibon, Laurent

(56) Documents cités:
- EP-A1- 2 439 583
- JP-A- 6 265 932
- KR-A- 20040 091 299
- US-A- 5 705 424
- US-B1- 6 452 652
- TOSHIO NAGATA ET AL: "A novel Silicon-On-Quartz (SOQ) device for optical mobile applications", ELECTRON DEVICES MEETING (IEDM), 2011 IEEE INTERNATIONAL, IEEE, 5 décembre 2011 (2011-12-05), pages 14.1.1-14.1.4, XP032095941, DOI: 10.1109/IEDM.2011.6131549 ISBN: 978-1-4577-0506-9

## Description

### Domaine de l'invention

La présente invention concerne un panneau constitué d'une matrice de cellules à cristaux liquides et destiné à être utilisé dans un nanoprojecteur.

### Exposé de l'art antérieur

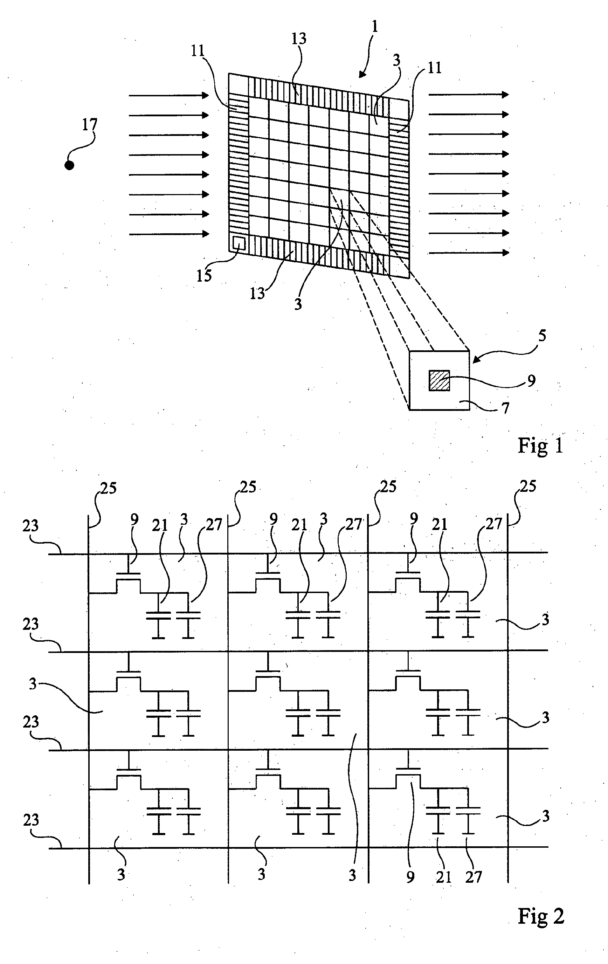

La figure 1 représente de façon schématique un panneau utilisé dans un nanoprojecteur pour projeter une image.

Le panneau 1 comprend une matrice de cellules 3 dont un agrandissement 5 est représenté en figure 1. Chaque cellule comprend une couche de cristaux liquides 7 encadrée par des électrodes transparentes supérieure et inférieure, non représentées en figure 1. Chaque cellule comprend en outre un transistor MOS de commande 9 disposé au-dessus de l'électrode supérieure. Les transistors 9 sont reliés à des décodeurs de rangée 11 et à des décodeurs de colonne 13. Le panneau 1 comprend en outre des circuits de pilotage 15 permettant de synchroniser l'allumage des cellules.

La lumière émise par une source lumineuse 17 traverse le panneau 1 et une image est projetée sur un écran (non représenté).

La figure 2 est un schéma électrique illustrant le fonctionnement d'un panneau du type de celui illustré en figure 1.

Pour chaque cellule 3, la couche de cristaux liquides 7 encadrée par les électrodes transparentes supérieure et inférieure constitue une capacité 21. L'électrode supérieure de la capacité 21 est reliée à une électrode principale du transistor MOS de commande 9 de la cellule. Le transistor 9 permet de commander le niveau d'atténuation optique de la cellule.

La grille de chaque transistor MOS de commande 9 est reliée à une rangée 23. La source de chaque transistor 9 est reliée à une colonne 25. Les niveaux de gris correspondant à l'image à projeter sont transmis à chaque cellule par une valeur de tension électrique envoyée sur chaque colonne 25. Ces valeurs sont transmises rangée par rangée aux transistors de commande 9.

La capacité 21 de chaque cellule de cristaux liquides est de valeur faible, par exemple de l'ordre de quelques fF. Des courants de fuite au niveau des transistors provoquent des pertes de signal entre deux opérations de rafraichissement de l'image. Une capacité de stockage 27 est donc prévue et disposée en parallèle avec la capacité 21 pour stocker suffisamment longtemps les données d'image.

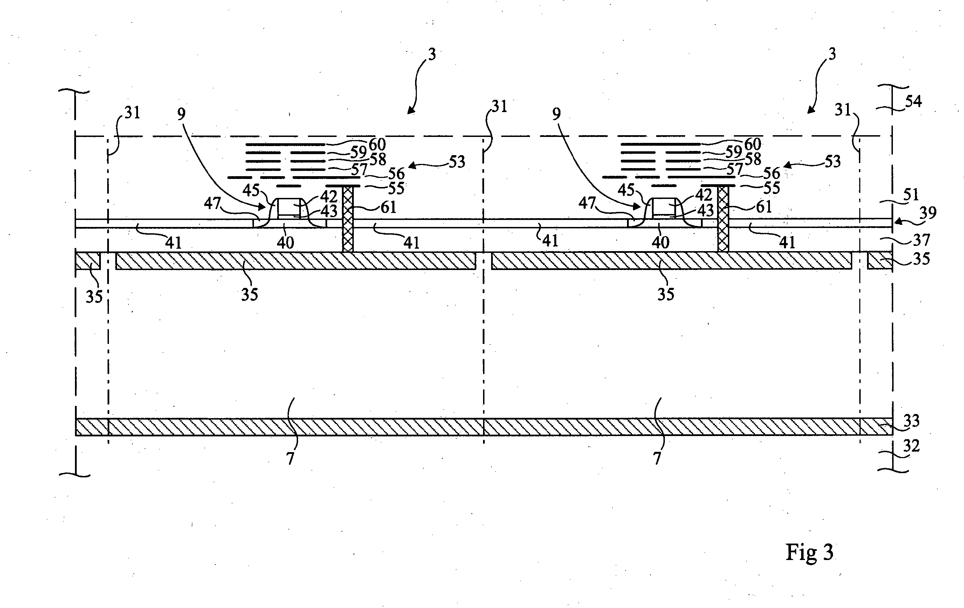

La figure 3 est une vue en coupe représentant de façon schématique une portion d'un panneau du type de celui illustré en figure 1. Des traits en pointillés 31 délimitent les cellules 3 entre elles.

Chaque cellule 3 comprend une couche de cristaux liquides 7 encadrée par une électrode transparente inférieure 33 et une électrode transparente supérieure 35. L'électrode transparente inférieure 33 repose sur une plaque transparente 32. L'électrode transparente inférieure 33 s'étend de façon continue sous la couche de cristaux liquides 7 et est commune à toutes les cellules 3, tandis qu'une électrode transparente supérieure 35 est associée à chaque cellule 3. Les électrodes supérieures 35 sont disposées à distance les unes des autres pour ne pas court-circuiter les cellules entre elles.

Une couche d'oxyde de silicium 37 recouverte d'une couche 39 est disposée au-dessus des électrodes supérieures 35. Comme on le verra ci-après dans le cadre d'un mode de réalisation de fabrication d'un panneau, les couches 37 et 39 correspondent respectivement à la couche d'oxyde enterré, couramment désignée par l'acronyme BOX ("Buried OXide"), et à la couche active d'un substrat de type silicium-sur-isolant (SOI - "Silicon-On-Insulator").

Pour chaque cellule 3, un transistor MOS de commande 9 a été formé dans une zone de silicium 40 de la couche 39, le reste, 41, de la couche 39 ayant été oxydé. On notera que les régions 41 sont transparentes. Chaque transistor MOS 9 comprend une grille 42 s'étendant sur la zone de silicium 40 et isolée de celle-ci par un isolant de grille 43. Des espaceurs 45 entourent la grille 42. Des régions de source et de drain 47 s'étendent dans la zone de silicium 40 de part et d'autre de la grille 42.

Les régions 41 de la couche 39 et les transistors MOS 9 ont été recouverts d'une couche isolante 51 elle-même recouverte de niveaux de métallisation 53 séparés par des couches isolantes. Les niveaux de métallisation 53 sont par exemple au nombre de six, désignés par les références 55 à 60. Une plaque transparente 54 recouvre la structure.

Pour chaque cellule 3, un via 61 en un matériau conducteur relie une métallisation du niveau de métallisation inférieur 55, reliée à une électrode principale du transistor MOS de commande 9, à l'électrode supérieure 35.

De façon générale, le niveau de métallisation inférieur 55 et le niveau de métallisation intermédiaire 56 sont utilisés pour réaliser les connexions des contacts de source, de drain et de grille des transistors de commande 9. Le niveau de métallisation supérieur 60 est utilisé pour l'alimentation des cellules.

Pour chaque cellule, le niveau de métallisation supérieur 60 s'étend au-dessus du transistor de commande 9 et sert d'écran optique pour protéger les transistors 9 des rayons lumineux.

Dans le cas d'une cellule comprenant six niveaux de métallisation, il reste au moins deux niveaux de métallisation, par exemple les niveaux intermédiaires 57, 58, 59, qui peuvent être utilisés pour former une capacité MIM (Métal Isolant Métal) intégrée au-dessus du transistor MOS de commande, cette capacité MIM constituant la capacité de stockage 27 de la cellule.

Par ailleurs, la surface utile de chaque cellule correspond à la surface de la cellule qui est susceptible d'être traversée par les rayons lumineux, ce qui exclut la surface occupée par les transistors.

Lorsqu'un panneau du type de celui illustré en figure 3 est utilisé dans un nanoprojecteur, un flux lumineux très intense arrive sur la surface du panneau, du côté des transistors MOS de commande. Un tel panneau est connu de EP 2 439 583.

Un inconvénient d'un tel panneau réside dans le fait que, malgré la présence du niveau de métallisation supérieur destiné à bloquer les rayons lumineux arrivant directement sur les transistors de commande, le fonctionnement des transistors de commande est perturbé par des rayonnements parasites. Il en résulte que les transistors MOS de commande présentent des courants de fuite élevés.

Un autre inconvénient d'un tel panneau réside dans la nécessité de former au moins cinq à six niveaux de métallisation au-dessus des transistors de commande pour pouvoir intégrer la capacité de stockage de chaque cellule au-dessus des transistors de commande, dans les niveaux de métallisation.

Or, pour réduire le coût de fabrication de panneaux destinés à être utilisés dans un nanoprojecteur, on est amené à réduire le nombre de niveaux de métallisation formés au-dessus des transistors de commande. Dans le cas où on veut former moins de cinq niveaux de métallisation, par exemple seulement trois niveaux de métallisation, la capacité de stockage des cellules ne peut pas être intégrée au-dessus des transistors de commande, les niveaux de métallisation étant tous utilisés pour réaliser les connexions des contacts de source, de drain et de grille des transistors de commande et pour alimenter les cellules. Pour chaque cellule, la capacité de stockage est alors réalisée à côté du transistor MOS de commande, par exemple sous la forme d'une capacité MOS. La surface utile de chaque cellule du panneau est alors réduite.

Il existe donc un besoin d'un panneau constitué d'une matrice de cellules à cristaux liquides destiné à être utilisé dans un nanoprojecteur palliant au moins en partie certains des inconvénients des panneaux décrits ci-dessus.

### Résumé

Ainsi, un objet d'un mode de réalisation de la présente invention est de prévoir un panneau constitué d'une matrice de cellules à cristaux liquides destiné à être utilisé dans un nanoprojecteur dans lequel les transistors MOS de commande sont protégés des rayons lumineux.

Un autre objet d'un mode de réalisation de la présente invention est de prévoir un panneau constitué d'une matrice de cellules à cristaux liquides destiné à être utilisé dans un nanoprojecteur comprenant des transistors MOS de commande recouverts de seulement trois niveaux de métallisation et dans lequel, pour chaque cellule, la capacité de stockage est intégrée dans la cellule sans réduire la surface utile de la cellule.

Pour atteindre ces objets, un mode de réalisation de la présente invention prévoit un panneau constitué d'une matrice de cellules destiné à être utilisé dans un nanoprojecteur, chaque cellule comprenant une couche de cristaux liquides encadrée par des électrodes transparentes supérieure et inférieure, un transistor MOS de commande étant disposé au-dessus de l'électrode supérieure, chaque transistor étant recouvert d'au moins trois niveaux de métallisation. Le transistor de chaque cellule s'étend dans un coin de la cellule de façon que les transistors d'un ensemble de quatre cellules adjacentes soient disposés dans une région centrale dudit ensemble ; le niveau de métallisation supérieur s'étend au-dessus des transistors de chaque ensemble de quatre cellules adjacentes ; et le panneau comprend, pour chaque ensemble de quatre cellules adjacentes, un premier anneau conducteur entourant les transistors, le premier anneau s'étendant du niveau de métallisation inférieur jusqu'à l'électrode supérieure de chaque cellule avec interposition d'un matériau isolant.

Selon un mode de réalisation de la présente invention, le panneau comprend en outre, pour chaque ensemble de quatre cellules adjacentes, un deuxième anneau conducteur et un troisième anneau conducteur entourant les transistors MOS de commande et s'étendant au-dessus du premier anneau conducteur, le deuxième anneau s'étendant du niveau de métallisation intermédiaire au niveau de métallisation inférieur et le troisième anneau s'étendant du niveau de métallisation supérieur au niveau de métallisation intermédiaire.

Selon un mode de réalisation de la présente invention, le panneau comprend en outre, pour chaque cellule, un via conducteur s'étendant d'une métallisation du niveau de métallisation inférieur, reliée à une électrode principale du transistor MOS de commande, à l'électrode transparente supérieure.

Selon un mode de réalisation de la présente invention, la largeur du premier anneau conducteur est comprise entre 0,2 et 0,3 µm.

Selon un mode de réalisation de la présente invention, le matériau isolant est de l'oxyde de silicium et a une épaisseur comprise entre 1 et 5 nm.

Un mode de réalisation de la présente invention prévoit un procédé de fabrication d'un panneau constitué d'une matrice de cellules destiné à être utilisé dans un nanoprojecteur, comprenant les étapes suivantes :
partir d'une plaquette comprenant un substrat semiconducteur recouvert d'une première couche isolante elle-même recouverte d'une couche semiconductrice ;
former des transistors MOS de commande dans des zones actives de la couche semiconductrice, le reste de la couche semiconductrice étant oxydé, le transistor de chaque cellule étant formé dans un coin de la cellule de façon que les transistors d'un ensemble de quatre cellules adjacentes soient disposés dans une région centrale dudit ensemble ;
déposer une seconde couche isolante sur la structure et former des premières ouvertures entourant les transistors de chaque dit ensemble de quatre cellules adjacentes, à partir de la surface supérieure de la seconde couche isolante jusqu'à atteindre le substrat ;
remplir les premières ouvertures d'un matériau conducteur de façon à former des premiers anneaux conducteurs ;
former au moins trois niveaux de métallisation au-dessus de chaque transistor, des métallisations du niveau de métallisation inférieur étant formées au-dessus du premier anneau conducteur, le niveau de métallisation supérieur étant formé de façon à recouvrir de façon continue les transistors de chaque dit ensemble de quatre cellules adjacentes ;
coller la face de la structure portant les niveaux de métallisation sur une première plaque transparente et éliminer le substrat de façon à découvrir les premiers anneaux conducteurs ;
former un matériau isolant au-dessus de chaque premier anneau conducteur ;
pour chaque cellule, recouvrir la première couche isolante et le matériau isolant d'une première électrode transparente ;
sur une seconde plaque transparente, former une seconde électrode transparente ; et
assembler les première et seconde plaques, de façon que les première et seconde électrodes transparentes soient en regard, avec interposition d'une couche de cristaux liquides.

Selon un mode de réalisation de la présente invention, le procédé comprend en outre, à l'étape de formation des niveaux de métallisation au-dessus de chaque transistor MOS de commande, les étapes suivantes :
former un deuxième anneau conducteur au-dessus du premier anneau conducteur, à partir du niveau de métallisation intermédiaire jusqu'au niveau de métallisation inférieur ; et
former un troisième anneau conducteur au-dessus du deuxième anneau conducteur, à partir du niveau de métallisation supérieur jusqu'au niveau de métallisation intermédiaire.

Selon un mode de réalisation de la présente invention :
à l'étape de formation des premières ouvertures entourant les transistors MOS de commande de chaque dit ensemble de quatre cellules adjacentes, des secondes ouvertures sont formées à partir de la surface supérieure de la seconde couche isolante jusqu'à atteindre le substrat ;
à l'étape de remplissage des premières ouvertures, les secondes ouvertures sont remplies du matériau conducteur de façon à former des vias ; et
à l'étape de formation des niveaux de métallisation, des métallisations du niveau de métallisation inférieur sont formées au-dessus des vias.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
la figure 1, décrite précédemment, représente de façon schématique un panneau utilisé dans un nanoprojecteur pour projeter une image ;
la figure 2, décrite précédemment, est un schéma électrique illustrant le fonctionnement d'un panneau utilisé dans un nanoprojecteur pour projeter une image ;
la figure 3, décrite précédemment, est une vue en coupe représentant de façon schématique une portion d'un panneau destiné à être utilisé dans un nanoprojecteur ;
la figure 4 est une vue en coupe représentant de façon schématique une portion d'un mode de réalisation d'un panneau destiné à être utilisé dans un nanoprojecteur ;
la figure 5, correspondant à la figure 4, est une vue de dessus représentant de façon schématique une portion d'un panneau destiné à être utilisé dans un nanoprojecteur ;
la figure 6 est une vue en coupe représentant de façon schématique une portion d'un autre mode de réalisation d'un panneau destiné à être utilisé dans un nanoprojecteur ; et
les figures 7A à 7E sont des vues en coupe illustrant de façon schématique des étapes successives d'un procédé de fabrication d'un panneau destiné à être utilisé dans un nanoprojecteur.

Par souci de clarté, de mêmes éléments ont été désignés par de mêmes références dans les différentes figures et, de plus, comme cela est habituel dans la représentation des circuits intégrés, les diverses figures ne sont pas tracées à l'échelle.

### Description détaillée

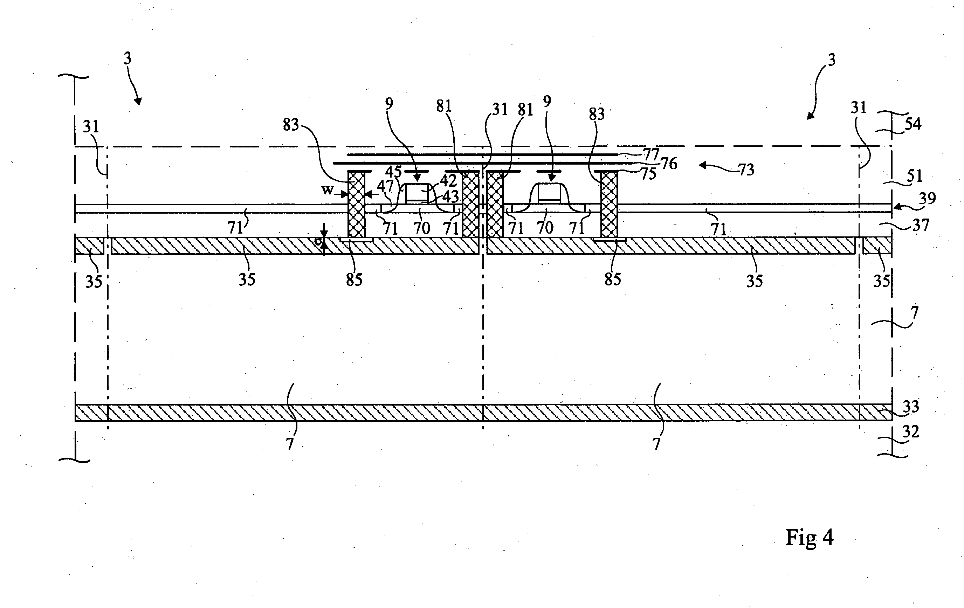

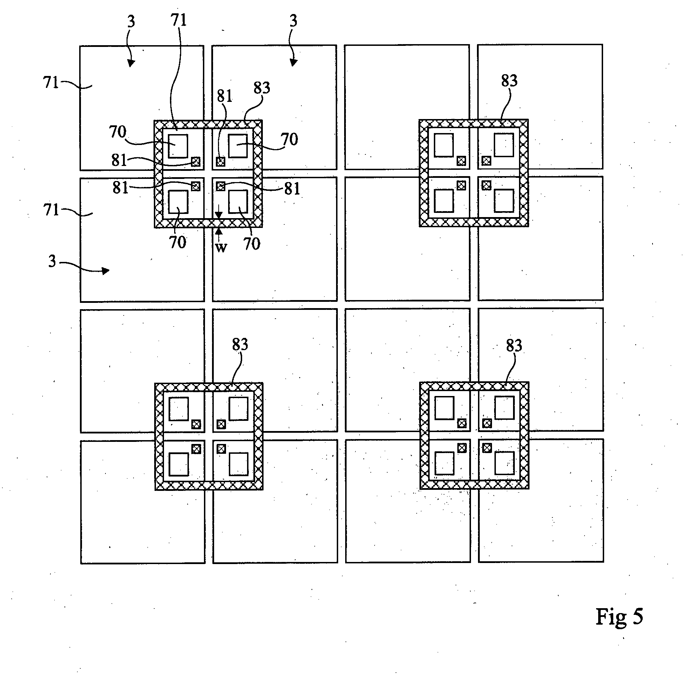

La figure 4 est une vue en coupe représentant de façon schématique une portion d'un panneau destiné à être utilisé dans un nanoprojecteur. Les éléments communs avec ceux de la figure 3 sont désignés par les mêmes références et ne sont pas décrits à nouveau ci-après. La figure 5 est une vue de dessus représentant des cellules du panneau illustré en figure 4, tous les éléments de la figure 4 n'étant pas représentés en figure 5.

Pour chaque cellule 3, un transistor MOS de commande 9 a été formé dans une zone de silicium 70 de la couche 39, située dans un coin de la cellule. Le reste, 71, de la couche 39 a été oxydé. Comme cela est visible en figure 5, les zones de silicium 70 sont disposées de façon que les transistors de commande de quatre cellules adjacentes se trouvent dans une région centrale de l'ensemble des quatre cellules.

Chaque transistor de commande 9 est recouvert de niveaux de métallisation 73, par exemple de seulement trois niveaux de métallisation 75, 76 et 77.

Le niveau de métallisation inférieur 75 et le niveau de métallisation intermédiaire 76, par exemple en cuivre, servent à former les connexions des contacts de source, de drain et de grille des transistors de commande 9, et à connecter les zones de silicium 70 à la masse. Le niveau de métallisation supérieur 77 sert à alimenter les cellules.

Pour chaque ensemble de quatre cellules adjacentes, le niveau de métallisation supérieur 77 s'étend de façon continue au-dessus des transistors de commande 9 et sert d'écran optique pour bloquer les rayons lumineux qui arriveraient directement sur les transistors de commande.

Pour chaque cellule, un via 81 en un matériau conducteur, par exemple en cuivre, relie une métallisation du niveau de métallisation inférieur 75, reliée à une électrode principale du transistor MOS de commande 9, à l'électrode supérieure 35. Les vias 81 sont par exemple disposés à des emplacements proches du centre de l'ensemble des quatre cellules.

Pour bloquer les rayonnements parasites pouvant arriver latéralement sur les transistors de commande 9, un anneau 83 en un matériau conducteur s'étend du niveau de métallisation inférieur 75 jusqu'à l'électrode supérieure 35 de chaque cellule, l'anneau 83 entourant les transistors de commande de quatre cellules adjacentes.

L'anneau conducteur 83 est en outre utilisé comme électrode de la capacité de stockage 27 disposée en parallèle avec la capacité 21 de chaque cellule de cristaux liquides.

Pour cela, un anneau 85 en un matériau isolant s'étend entre l'anneau conducteur 83 et l'électrode supérieure 35 de chaque cellule. L'anneau isolant 85 constitue le diélectrique de la capacité de stockage 27 de chaque cellule, l'anneau conducteur 83 une de ses électrodes, et l'électrode supérieure 35 l'autre de ses électrodes.

L'anneau conducteur 83 est relié à la masse, comme l'électrode inférieure 33 commune à toutes les cellules, conformément au schéma électrique de la figure 2.

La largeur W de l'anneau conducteur 83 et l'épaisseur e de l'anneau isolant 85 et sa nature sont choisis de façon à obtenir la valeur souhaitée pour la capacité de stockage.

Un avantage d'un panneau du type de celui illustré en figures 4 et 5 réside dans le fait que les transistors de commande sont protégés des rayons lumineux arrivant directement sur les transistors de commande, comme précédemment, par le niveau de métallisation supérieur, et des rayonnements parasites latéraux par les anneaux conducteurs entourant les transistors de commande de quatre cellules adjacentes.

Un autre avantage d'un tel panneau est lié au fait que l'anneau conducteur entourant les transistors de commande de quatre cellules adjacentes, destiné à protéger les transistors de commande des rayonnements parasites, constitue également une électrode de la capacité de stockage de chaque cellule. Ainsi, les transistors de commande peuvent être recouverts de seulement trois niveaux de métallisation sans qu'il soit nécessaire de former la capacité de stockage de chaque cellule à côté des transistors de commande, et donc sans réduire la surface utile des cellules.

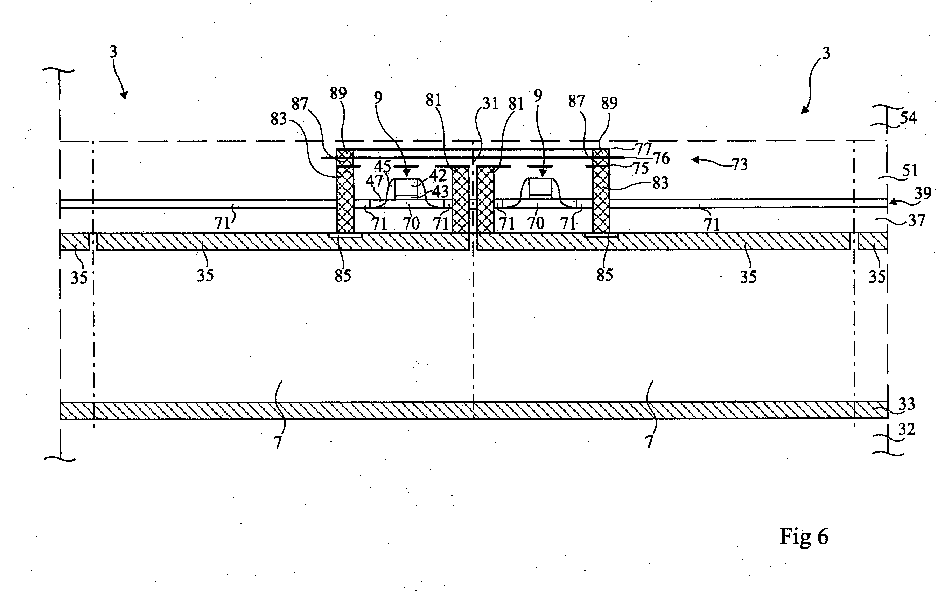

La figure 6 est une vue en coupe représentant de façon schématique une portion d'une variante d'un panneau destiné à être utilisé dans un nanoprojecteur.

En plus de l'anneau conducteur 83 entourant les transistors de commande de quatre cellules adjacentes, des anneaux conducteurs 87 et 89 sont disposés au-dessus de l'anneau 83 pour améliorer encore la protection des transistors de commande 9 contre des rayonnements parasites.

L'anneau 87 s'étend du niveau de métallisation intermédiaire 76 au niveau de métallisation inférieur 75. L'anneau 89 s'étend du niveau de métallisation supérieur 77 au niveau de métallisation intermédiaire 76. Les anneaux 87 et 89 sont par exemple constitués du même matériau conducteur que l'anneau 83.

Dans un panneau du type de celui illustré en figure 6, les transistors de commande de quatre cellules adjacentes sont entièrement entourés de matériau opaque, au-dessus par le niveau de métallisation supérieur 77 continu et latéralement par les anneaux conducteurs 83, 87 et 89.

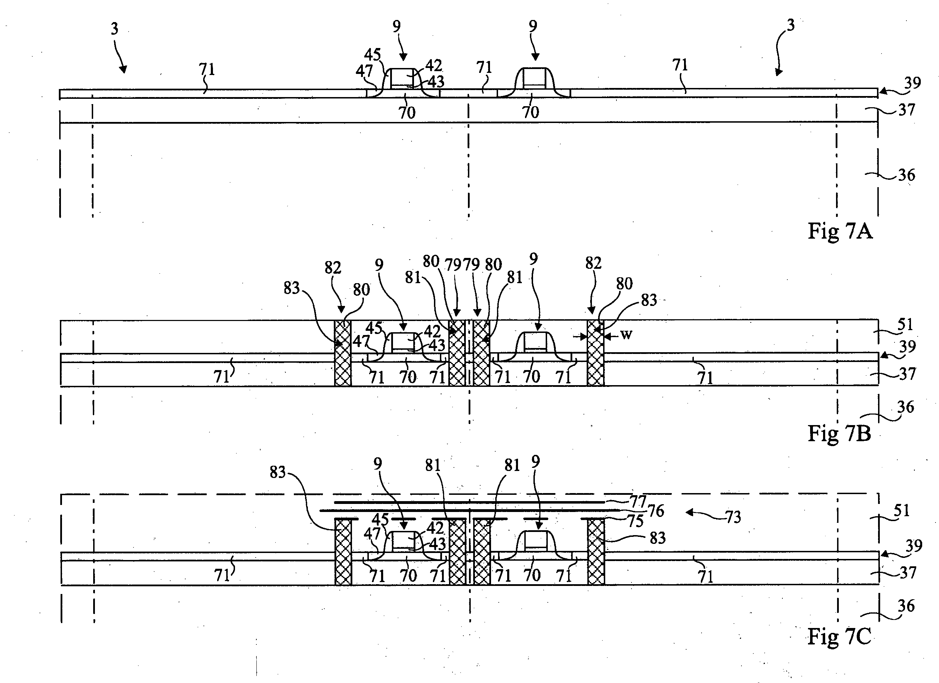

Les figures 7A à 7E sont des vues en coupe illustrant de façon schématique des étapes successives d'un procédé de fabrication d'un panneau du type de celui illustré en figures 4 et 5.

La figure 7A est une vue en coupe représentant de façon schématique un substrat de type SOI ("Silicon-On-Insulator", silicium-sur-isolant) dans lequel des transistors MOS ont été formés.

Un substrat semiconducteur 36, par exemple un substrat de silicium, est recouvert d'une couche isolante 37, par exemple en oxyde de silicium, couramment désignée dans la technique par l'acronyme BOX ("Buried OXide", oxyde enterré), elle-même recouverte d'une couche semiconductrice 39, par exemple en silicium monocristallin. L'épaisseur de la couche semiconductrice 39 est par exemple comprise entre 50 et 250 nm, par exemple de l'ordre de 150 nm.

Des transistors MOS 9 ont été formés dans des zones actives 70 de la couche semiconductrice 39. Chaque transistor MOS 9 comprend une grille conductrice 42 isolée de la surface de la couche semiconductrice 39 par un isolant de grille 43, des espaceurs 45 entourant la grille 42, et des régions de source et de drain 47. Chaque transistor MOS 9 correspond à un transistor de commande d'une cellule 3 du panneau. Les transistors MOS 9 ont été formés dans un coin des cellules 3 de façon que les transistors de commande de quatre cellules adjacentes se trouvent dans une région centrale de l'ensemble des quatre cellules. En dehors des zones actives 70, la couche semiconductrice 39 a été oxydée, ce qui correspond à des régions 71 en oxyde de silicium transparent.

La figure 7B illustre la structure après le dépôt d'une couche isolante 51 sur la structure. Pour chaque cellule, une ouverture 79 a été formée, par exemple dans un coin de la cellule, à côté de la zone active 70, à partir de la surface supérieure de la couche isolante 51 jusqu'à atteindre le substrat semiconducteur 36. En même temps que les ouvertures 79, des ouvertures 82 entourant les transistors de commande de quatre cellules adjacentes ont été formées à partir de la surface supérieure de la couche isolante 51 jusqu'à atteindre le substrat semiconducteur 36. Les ouvertures 79 et 82 ont ensuite été remplies d'un matériau conducteur 80, par exemple du cuivre. Les ouvertures 79 et 82 remplies du matériau conducteur 80 constituent respectivement des vias 81 et des anneaux 83 s'étendant jusqu'au substrat semiconducteur 36.

A titre d'exemple d'ordre de grandeur, la largeur W de chaque anneau conducteur 83 est par exemple comprise entre 0,2 et 0,3 µm, par exemple de l'ordre de 0,25 µm.

La figure 7C illustre la structure après la formation de niveaux de métallisation 73, par exemple trois niveaux de métallisation 75, 76, 77, par exemple en cuivre, au-dessus des transistors MOS. Des métallisations du niveau de métallisation inférieur 75 sont disposées au-dessus des vias 81 et au-dessus de l'anneau 83. Le niveau de métallisation supérieur 77 est formé de façon à recouvrir de façon continue les transistors MOS de commande 9 de chaque ensemble de quatre cellules adjacentes.

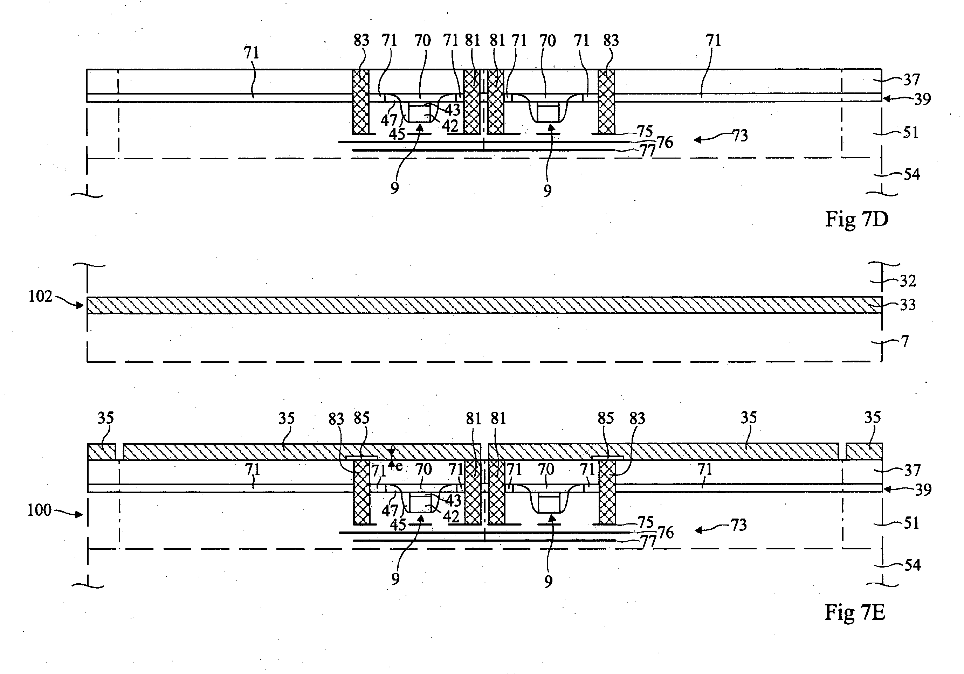

La figure 7D illustre la structure après collage de la face de la structure portant les niveaux de métallisation 73 sur une plaque transparente 54, par exemple en verre, et après élimination du substrat semiconducteur 36. Les anneaux conducteurs 83 débouchent alors en surface.

La figure 7E illustre la formation d'un anneau 85 en un matériau isolant au-dessus de la face apparente de l'anneau conducteur 83. L'anneau isolant 85 est par exemple en oxyde de silicium ou en un matériau à forte permittivité diélectrique. L'anneau isolant 85 a par exemple une épaisseur e comprise entre 1 et 5 nm, par exemple de l'ordre de 2 nm. Pour chaque cellule 3, une électrode transparente 35 a ensuite été formée au-dessus de la couche isolante 37 et au-dessus de l'anneau isolant 85. On obtient ainsi une plaque 100.

Sur une autre plaque transparente 32, par exemple en verre, une électrode transparente 33 a été formée pour constituer une plaque 102.

Les plaques 100 et 102 sont alors mises en regard, des espaceurs sont mis en place et une couche de cristaux liquides 7 est insérée entre les plaques 100 et 102. On obtient alors une structure du type de celle illustrée en figure 4.

Les électrodes transparentes 33 et 35 sont par exemple en ITO ("Indium Tin Oxide" - oxyde d'indium-étain).

Pour former un panneau du type de celui illustré en figure 6, les anneaux conducteurs 87 et 89 sont formés à l'étape de formation des niveaux de métallisation illustrée en figure 7C d'un procédé du type de celui décrit ci-dessus.

L'anneau conducteur 87 est formé au-dessus de l'anneau conducteur 83 après la formation du niveau de métallisation inférieur 75. L'anneau conducteur 89 est formé au-dessus de l'anneau conducteur 87 après la formation du niveau de métallisation intermédiaire 76.

Des modes de réalisation particuliers de la présente invention ont été décrits. Diverses variantes et modifications apparaîtront à l'homme de l'art.

En particulier, bien que l'on ait décrit un panneau comprenant une couche isolante 37 en oxyde de silicium, la couche 37 pourra être constituée de tout autre matériau isolant transparent.

Bien que l'on ait décrit des régions 71 de la couche 39 en oxyde de silicium, les régions 71 pourront être constituées de tout autre matériau isolant transparent.

Bien que l'on ait décrit que l'anneau conducteur 83 est en un matériau conducteur, l'anneau 83 pourra comprendre plusieurs couches de matériaux conducteurs différents. Il en est de même pour les anneaux conducteurs 87 et 89.

## Revendications

1. Panneau constitué d'une matrice de cellules (3) destiné à être utilisé dans un nanoprojecteur, chaque cellule comprenant une couche de cristaux liquides (7) encadrée par des électrodes transparentes supérieure (35) et inférieure (33), un transistor MOS de commande (9) étant disposé au-dessus de l'électrode supérieure, chaque transistor étant recouvert, d'au moins trois niveaux de métallisation (75, 76, 11), **caracterisé en ce que** - le transistor de chaque cellule s'étend dans un coin de la cellule de façon que les transistors d'un ensemble de quatre cellules adjacentes soient disposés dans une région centrale dudit ensemble ;
le niveau de métallisation supérieur (77) s'étend au-dessus des transistors de chaque dit ensemble de quatre cellules adjacentes ; et
le panneau comprend, pour chaque dit ensemble de quatre cellules adjacentes, un premier anneau conducteur (83) entourant les transistors, le premier anneau s'étendant du niveau de métallisation inférieur (75) jusqu'à l'électrode supérieure de chaque cellule avec interposition d'un matériau isolant (85).

2. Panneau selon la revendication 1, comprenant en outre, pour chaque dit ensemble de quatre cellules adjacentes, un deuxième anneau conducteur (87) et un troisième anneau conducteur (89) entourant les transistors MOS de commande (9) et s'étendant au-dessus du premier anneau conducteur (83), le deuxième anneau s'étendant du niveau de métallisation intermédiaire (76) au niveau de métallisation inférieur (75) et le troisième anneau s'étendant du niveau de métallisation supérieur (77) au niveau de métallisation intermédiaire (76).

3. Panneau selon la revendication 1 ou 2, comprenant en outre, pour chaque cellule (3), un via conducteur (81) s'étendant d'une métallisation du niveau de métallisation inférieur (75), reliée à une électrode principale du transistor MOS de commande (9), à l'électrode transparente supérieure (35).

4. Panneau selon l'une quelconque des revendications 1 à 3, dans lequel la largeur du premier anneau conducteur (83) est comprise entre 0,2 et 0,3 µm.

5. Panneau selon l'une quelconque des revendications 1 à 4, dans lequel le matériau isolant (85) est de l'oxyde de silicium et a une épaisseur comprise entre 1 et 5 nm.

6. Procédé de fabrication d'un panneau constitué d'une matrice de cellules (3) destiné à être utilisé dans un nanoprojecteur, comprenant les étapes suivantes
partir d'une plaquette comprenant un substrat semiconducteur (36) recouvert d'une première couche isolante (37) elle-même recouverte d'une couche semiconductrice (39) ;
former des transistors MOS de commande (9) dans des zones actives (70) de la couche semiconductrice (39), le reste (71) de la couche semiconductrice étant oxydé, le transistor de chaque cellule étant formé dans un coin de la cellule de façon que les transistors d'un ensemble de quatre cellules adjacentes soient disposés dans une région centrale dudit ensemble ;
déposer une seconde couche isolante (51) sur la structure et former des premières ouvertures (82) entourant les transistors de chaque dit ensemble de quatre cellules adjacentes, à partir de la surface supérieure de la seconde couche isolante jusqu'à atteindre le substrat ;
remplir les premières ouvertures (82) d'un matériau conducteur (80) de façon à former des premiers anneaux conducteurs (83) ;
former au moins trois niveaux de métallisation (75, 76, 77) au-dessus de chaque transistor, des métallisations du niveau de métallisation inférieur (75) étant formées au-dessus du premier anneau conducteur, le niveau de métallisation supérieur (77) étant formé de façon à recouvrir de façon continue les transistors de chaque dit ensemble de quatre cellules adjacentes ;
coller la face de la structure portant les niveaux de métallisation sur une première plaque transparente (54) et éliminer le substrat de façon à découvrir les premiers anneaux conducteurs ;
former un matériau isolant (85) au-dessus de chaque premier anneau conducteur ;
pour chaque cellule, recouvrir la première couche isolante et le matériau isolant d'une première électrode transparente (35) ;
sur une seconde plaque transparente (32), former une seconde électrode transparente (33) ; et
assembler les première et seconde plaques, de façon que les première et seconde électrodes transparentes soient en regard, avec interposition d'une couche de cristaux liquides (7).

7. Procédé selon la revendication 6, comprenant en outre, à l'étape de formation des niveaux de métallisation (75, 76, 77) au-dessus de chaque transistor MOS de commande (9), les étapes suivantes :
former un deuxième anneau conducteur (87) au-dessus du premier anneau conducteur (83), à partir du niveau de métallisation intermédiaire (76) jusqu'au niveau de métallisation inférieur (75) ; et
former un troisième anneau conducteur (89) au-dessus du deuxième anneau conducteur (87), à partir du niveau de métal-lisation supérieur (77) jusqu'au niveau de métallisation intermédiaire (76).

8. Procédé selon la revendication 6 ou 7, dans lequel :
à l'étape de formation des premières ouvertures (82) entourant les transistors MOS de commande (9) de chaque dit ensemble de quatre cellules adjacentes, des secondes ouvertures (79) sont formées à partir de la surface supérieure de la seconde couche isolante (51) jusqu'à atteindre le substrat (36) ;
à l'étape de remplissage des premières ouvertures (82), les secondes ouvertures (79) sont remplies du matériau conducteur (80) de façon à former des vias (81) ; et
à l'étape de formation des niveaux de métallisation (75, 76, 77), des métallisations du niveau de métallisation inférieur (75) sont formées au-dessus des vias.

## Patentansprüche

1. Ein Panel aus einer Anordnung von Zellen (3) zur Verwendung in einem Nanoprojektor, wobei jede Zelle eine Flüssigkristallschicht (7) umgeben mit oberen (35) und unteren (33) transparenten Elektroden aufweist, und wobei ein MOS Steuertransistor (9) oberhalb der oberen Elektrode angeordnet ist, wobei jeder Transistor mit mindestens drei Metallisierungsniveaus (75, 76, 77) abgedeckt ist,
**dadurch gekennzeichnet, dass**:
der Transistor jeder Zelle sich in einer Ecke der Zelle derart erstreckt, dass die Transistoren einer Anordnung aus vier benachbarten Zellen in einer mittleren Zone der Anordnung angeordnet sind;
das obere Metallisierungsniveau (77) sich oberhalb der Transistoren der erwähnten Anordnung von vier benachbarten Zellen erstreckt; und
das Panel für jede der erwähnten Anordnung aus vier benachbarten Zellen einen ersten leitenden Ring (83) aufweist, der die Transistoren umgibt, wobei der erste Ring sich von dem unteren Metallisierungsniveau (75) zu der oberen Elektrode jeder Zelle mit einem dazwischen angeordneten Isoliermaterial (85) erstreckt.

2. Das Panel nach Anspruch 1, wobei ferner für jede der erwähnten Anordnungen aus vier benachbarten Zellen ein zweiter leitender Ring (87) und ein dritter leitender Ring (89) die MOS Steuertransistoren (9) umgebend, und sich oberhalb des ersten leitenden Rings (83) erstreckend vorgesehen ist, wobei der zweite Ring sich von dem Zwischen-Metallisierungsniveau (76) zum unteren Metallisierungsniveau (75) erstreckt, und wobei der dritte Ring sich von dem oberen Metallisierungsniveau (77) zu dem Zwischen-Metallisierungsniveau (76) erstreckt.

3. Das Panel nach Anspruch 1 oder 2, wobei ferner für jede Zelle (3) eine leitende Via (81) vorgesehen ist, die sich von einer Metallisierung des unteren Metallisierungsniveaus (75) verbunden mit einer Hauptelektrode des MOS Steuertransistors (9), zu der oberen transparenten Elektrode (35) erstreckt.

4. Das Panel nach einem der Ansprüche 1 bis 3, wobei die Breite des ersten leitenden Rings (83) im Bereich zwischen 0,2 und 0,3 µm liegt.

5. Das Panel nach einem der Ansprüche 1 bis 4, wobei das Isoliermaterial (85) Siliziumoxid ist und eine Dicke im Bereich zwischen 1 und 5 nm besitzt.

6. Ein Verfahren zur Herstellung eines Panels gebildet aus einer Anordnung von Zellen (3) die für die Verwendung in einem Nanoprojektor vorgesehen sind, wobei das Verfahren die folgenden Schritte aufweist:
Starten, ausgehend von einem Wafer, der ein Halbleitersubstrat (36) aufweist, beschichtet mit einer ersten Isolierschicht (37), die selbst mit einer Halbleiterschicht (39) beschichtet ist;
Formen von MOS Steuertransistoren (9) in aktiven Gebieten (70) der Halbleiterschicht (39), wobei der Rest (71) der Halbleiterschicht oxidiert ist, wobei der Transistor jeder Zelle in einer Ecke der Zelle derart geformt ist, dass die Transistoren einer Anordnung von vier benachbarten Zellen in einem mittleren Bereich der Anordnung angeordnet sind;
Abscheiden einer zweiten Isolierschicht (51) auf der Struktur und Bilden von ersten Öffnungen (82), die die Transistoren jeder Anordnung von vier benachbarten Zellen umgeben, und zwar ausgehend von der oberen Oberfläche der zweiten Isolierschicht den ganzen Weg zum Substrat;
Füllen der ersten Öffnungen (82) mit einem leitenden Material (80) zur Bildung erster leitender Ringe (83);
Formen von mindestens drei Metallisierungsniveaus (75, 76, 77) oberhalb jedes Transistors, wobei die Metallisierungen des unteren Metallisierungsniveaus (75) oberhalb des ersten leitenden Rings geformt sind, wobei das obere Metallisierungsniveau (77) derart geformt ist, um kontinuierlich die Transistoren jeder Anordnung von vier benachbarten Zellen abzudecken;
Verbinden der Oberfläche der Struktur, die die Metallisierungsniveaus trägt mit einer ersten transparenten Platte (54) und Entfernen des Substrats zum Freilegen der ersten leitenden Ringe;
Formen eines Isoliermaterials (85) oberhalb jedes ersten leitenden Rings;
Abdecken, für jede Zelle, der ersten Isolierschicht und des Isoliermaterials mit einer ersten transparenten Elektrode (35);
Bilden auf einer zweiten transparenten Platte (32) eine zweite transparente Elektrode (33); und
Zusammenbauen der ersten und zweiten Platten, so dass die ersten und zweiten transparenten Elektroden einander gegenüberliegen und zwar mit einer dazwischen angeordneten Flüssigkristallschicht (7).

7. Das Verfahren nach Anspruch 6, wobei ferner vorgesehen ist, dass beim Schritt des Formens der Metallisierungsniveaus (75, 76, 77) oberhalb jedes MOS Steuertransistors (9), die folgenden Schritte vorgesehen sind:
Formen eines zweiten leitenden Rings (87) oberhalb des ersten leitenden Rings (83) vom Zwischen-Metallisierungsniveau (76) zum unteren Metallisierungsniveau (75); und
Formen eines dritten leitenden Rings (89) oberhalb des zweiten leitenden Rings (87) vom oberen Metallisierungsniveau (77) zu dem Zwischen-Metallisierungsniveau (76).

8. Das Verfahren nach Anspruch 6 oder 7,
wobei beim Schritt des Formens der ersten Öffnungen (82), die die MOS Steuertransistoren (9) jeder der Anordnung von vier benachbarten Zellen umgeben, zweite Öffnungen (79) geformt werden, und zwar von der oberen Oberfläche der zweiten Isolierschicht (51) zum Erreichen des Substrats (36);
wobei beim Schritt des Füllens der ersten Öffnungen (82) die zweiten Öffnungen (79) mit dem leitenden Material (80) gefüllt werden zur Bildung von Vias (81); und
wobei beim Schritt des Formens der Metallisierungsniveaus (75, 76, 77) die Metallisierungen des unteren Metallisierungsniveaus (75) oberhalb der Vias geformt werden.

## Claims

1. A panel formed of an array of cells (3) intended to be used in a nanoprojector, each cell comprising a liquid crystal layer (7) surrounded with upper (35) and lower (33) transparent electrodes, a MOS control transistor (9) being arranged above the upper electrode, each transistor being covered with at least three metallization levels (75, 76, 77), **characterized in that**:
the transistor of each cell extends in a corner of the cell so that the transistors of an assembly of four adjacent cells are arranged in a central region of said assembly;
the upper metallization level (77) extends above the transistors of each said assembly of four adjacent cells; and
the panel comprises, for each said assembly of four adjacent cells, a first conductive ring (83) surrounding the transistors, the first ring extending from the lower metallization level (75) to the upper electrode of each cell with an interposed insulating material (85).

2. The panel of claim 1, further comprising, for each said assembly of four adjacent cells, a second conductive ring (87) and a third conductive ring (89) surrounding the MOS control transistors (9) and extending above the first conductive ring (83), the second ring extending from the intermediate metallization level (76) to the lower metallization level (75) and the third ring extending from the upper metallization level (77) to the intermediate metallization level (76).

3. The panel of claim 1 or 2, further comprising, for each cell (3), a conductive via (81) extending from a metallization of the lower metallization level (75), connected to a main electrode of the MOS control transistor (9), to the upper transparent electrode (35).

4. The panel of any of claims 1 to 3, wherein the width of the first conductive ring (83) ranges between 0.2 and 0.3 µm.

5. The panel of any of claims 1 to 4, wherein the insulating material (85) is silicon oxide and has a thickness ranging between 1 and 5 nm.

6. A method for manufacturing a panel formed of an array of cells (3) intended to be used in a nanoprojector, comprising the steps of:
starting from a wafer comprising a semiconductor substrate (36) covered with a first insulating layer (37) itself covered with a semiconductor layer (39);
forming MOS control transistors (9) in active areas (70) of the semiconductor layer (39), the rest (71) of the semiconductor layer being oxidized, the transistor of each cell being formed in a corner of the cell so that the transistors of an assembly of four adjacent cells are arranged in a central region of said assembly;
depositing a second insulating layer (51) on the structure and forming first openings (82) surrounding the transistors of each said assembly of four adjacent cells, from the upper surface of the second insulating layer all the way to the substrate;
filling the first openings (82) with a conductive material (80) to form first conductive rings (83);
forming at least three metallization levels (75, 76, 77) above each transistor, metallizations of the lower metallization level (75) being formed above the first conductive ring, the upper metallization level (77) being formed so as to continuously cover the transistors of each said assembly of four adjacent cells;
bonding the surface of the structure supporting the metallization levels to a first transparent plate (54) and removing the substrate to expose the first conductive rings;
forming an insulating material (85) above each first conductive ring;
for each cell, covering the first insulating layer and the insulating material with a first transparent electrode (35);
on a second transparent plate (32), forming a second transparent electrode (33); and
assembling the first and second plates, so that the first and second transparent electrodes are in front of each other, with an interposed liquid crystal layer (7).

7. The method of claim 6, further comprising, at the step of forming of the metallization levels (75, 76, 77) above each MOS control transistor (9), the steps of:
forming a second conductive ring (87) above the first conductive ring (83), from the intermediate metallization level (76) to the lower metallization level (75); and
forming a third conductive ring (89) above the second conductive ring (87), from the upper metallization level (77) to the intermediate metallization level (76).

8. The method of claim 6 or 7, wherein:
at the step of forming of the first openings (82) surrounding the MOS control transistors (9) of each said assembly of four adjacent cells, second openings (79) are formed from the upper surface of the second insulating layer (51) to reach the substrate (36);
at the step of filing of the first openings (82), the second openings (79) are filled with the conductive material (80) to form vias (81); and
at the step of forming of the metallization levels (75, 76, 77), metallizations of the lower metallization level (75) are formed above the vias.
